# EUROPEAN PATENT SPECIFICATION

(11) **EP 3 071 006 B1**
(45) Date of publication and mention of the grant of the patent: **25.12.2019**
(21) Application number: 13897023.1
(22) Date of filing: 11.11.2013
(51) Int. Cl.: H05K 13/04, B05C 5/02

(54) **SUBSTRATE PROCESSING DEVICE AND DISPENSING HEAD**
SUBSTRATVERARBEITUNGSVORRICHTUNG UND ABGABEKOPF
DISPOSITIF DE TRAITEMENT DE SUBSTRAT ET TÊTE DE DISTRIBUTION

(43) Date of publication of application: 21.09.2016
(73) Proprietor: FUJI Corporation, Chiryu Aichi (JP)
(72) Inventor: TESHIMA, Chikashi, Chiryu Aichi 472-8686 (JP)
(74) Representative: Grünecker Patent- und Rechtsanwälte PartG mbB
(86) International application number: PCT/JP2013/080392
(87) International publication number: WO 2015/068297

(56) References cited:
- EP-A2- 0 473 911
- WO-A1-2012/014467
- WO-A2-2005/009627
- JP-A- H1 099 756
- JP-A- 2003 110 289
- JP-A- 2004 111 424
- JP-A- 2007 073 981
- JP-A- 2013 038 358
- US-A- 4 572 103
- US-A1- 2009 107 398
- US-A1- 2012 151 756

## Description

### Technical Field

The present invention relates to a board work device and a dispensing head.

### Background Art

Board work devices that perform dispensing of viscous fluids and mounting of components onto circuit boards are known. For example, an electronic component holding device provided with a dispenser head (dispensing head) that dispenses a viscous fluid, a nozzle head that picks up and holds a component, and a head holding body that alternately holds the dispenser head and the nozzle head is disclosed in patent literature 1. In this electronic component holding device, a passage is formed inside the head holding body. This passage, when the head holding body is holding a dispenser head, is connected to a dispensing nozzle and a liquid storage section of the dispenser head. Also, a switching device is connected to the passage inside the head holding body. The switching device alternately supplies positive pressure or negative pressure to the passage. Also, by the switching device supplying positive pressure to the passage with the head holding body holding the dispenser head, positive pressure is supplied to the liquid storage section of the dispenser head via the passage, such that viscous fluid is dispensed from the dispensing nozzle.

Patent Literature 2 discloses a further example of a board work device.

### Citation List

### Patent Literature

Patent Literature 1: JP-A-2007-73981
Patent Literature 2: US 2012/151756 A1

### Summary of Invention

### Technical Problem

However, with patent literature 1, pressure from the switching device is supplied to the dispensing head via the passage inside the head holding body. Therefore, when the pressure supplied to the head is switched, such as in cases when the switching device is operated, the pressure response at the dispensing head side is slow in some cases.

The present invention takes account of the above circumstances, and an object thereof is to improve the responsiveness of a dispensing head with respect to pressure switching.

### Solution to Problem

The present invention is a board work device according to the features of independent claim 1. Preferred embodiments are laid down in the dependent claims.

The present invention of a board work device is provided with a dispensing head and a head holding means capable of holding the dispensing head. The dispensing head is provided with a valve mechanism that is capable of switching to a first state in which viscous fluid at the viscous fluid dispensing outlet is pushed and dispensed via the viscous fluid housing chamber and a second state in which the viscous fluid cannot be dispensed. When the operation entry section enters an operation from an external section, the switching section switches the valve mechanism based on the entered operation. In this way, by the valve mechanism provided in the dispensing head, the dispensing head of the present invention is capable of switching to and from a state in which the dispensing head can dispense and a state in which the dispensing head cannot dispense, that is, it is capable of switching the pressure. Thus, compared to a case, for example, in which a valve mechanism is provided on the head holding means that holds the dispensing head, the distance from the point at which the pressure changes due to the switching of the valve mechanism to the viscous fluid dispensing outlet is smaller. This improves the responsiveness of the dispensing head with respect to the switching of the pressure. Here, "operation from an external section" includes a mechanical operation or an electrical operation. "Viscous fluid" includes materials such as adhesive, solder, and brazing material. "The dispensing head cannot dispense" includes cases in which pressure cannot be imparted to the viscous fluid dispensing outlet via the viscous fluid housing chamber (open to the atmosphere), and cases in which negative pressure can be applied to the viscous fluid dispensing outlet via the viscous fluid housing chamber.

With the present invention of a board work device, the head holding means exchangeably holds the dispensing head or a mounting head that holds and releases a component, and includes an operation section that operates the held mounting head, and the operation entry section is capable of entering an operation from the operation section in a state where the dispensing head is held by the head holding means. In this way, the head holding means is capable of switching the valve mechanism of the dispensing head using the operation section that uses an operation of the mounting head. That is, the operation section of the head holding means is capable of being used for both operation of the mounting head and operation of the dispensing head. By this, compared to a case in which, for example, the head holding means is provided with an operation section for dispensing head use that is not used for operation of the mounting head, the configuration of the head holding means is simpler. Also, the head holding means created for exchangeably holding the mounting head can be used for holding a dispensing head without providing a new operation section. Note that, it is acceptable merely for the head holding means to be capable of holding a mounting head, the board work device in this case may or may not be provided with a mounting head.

In this case, the operation section of the head holding means, in a state where the head holding means is holding the mounting head, may be capable of operating an axis rotating mechanism of the mounting head that axially rotates at least one of multiple component holding tools which are capable of holding and releasing a component, and in a state where the head holding means is holding the dispensing head, may be capable of operating the operation entry section. In this way, the head holding means operates the dispensing head using the operation section that performs operation of the axis rotating mechanism of the mounting head.

With the present invention of a board work device, the operation entry section may be exposed at a connection surface with the head holding means when the dispensing head is held by the head holding means. By the operation entry section being exposed at the connection surface, the operation entry section contacts the head holding section when the dispensing head is held by the head holding means, thus it becomes easier to operate the operation entry section from the head holding means side.

With the present invention of a board work device, the dispensing head may be provided with a first opening through which positive pressure is supplied via the head holding means in a state with the dispensing head being held in the head holding means, and a second opening through which negative pressure is supplied via the head holding means in a state with the dispensing head being held in the head holding means; the head holding means may be provided with a first supply outlet that is connected to the first opening and that supplies positive pressure in a state with the head holding means holding the dispensing head, and a second supply outlet that is connected to the second opening and that supplies negative pressure in a state with the head holding means holding the dispensing head; and the valve mechanism may be capable of switching to a first state in which the viscous fluid dispensing outlet is connected to the first opening via the viscous fluid housing chamber and not connected to the second opening, and a second state in which the viscous fluid dispensing outlet is connected to the second opening via the viscous fluid housing chamber and not connected to the first opening. By this, by switching such that the viscous fluid housing chamber is connected to either the first opening or the second opening, it is possible to perform switching of the pressure.

With the present invention of a work device, the valve mechanism may be capable of switching to the first state, the second state, and a third state in which the viscous fluid dispensing outlet is connected to the atmosphere via the viscous fluid housing chamber.

The dispensing head comprises: a viscous fluid housing chamber that houses the viscous fluid; a viscous fluid dispensing outlet connected to the viscous fluid housing chamber; a valve mechanism that switches to a first state in which viscous fluid at the viscous fluid dispensing outlet is pushed and dispensed via the viscous fluid housing chamber and a second state in which the viscous fluid cannot be dispensed; an operation entry section that enters operations from an external section; and a switching section that switches the valve mechanism based on an operation entered by the operation entry section.

By the valve mechanism provided in the dispensing head, the dispensing head of the present invention is capable of switching to and from a state in which the dispensing head can dispense and a state in which the dispensing head cannot dispense, that is, it is capable of switching the pressure. Thus, compared to a case, for example, in which a valve mechanism is provided on the head holding means that holds the dispensing head, the distance from the point at which the pressure changes due to the switching of the valve mechanism to the viscous fluid dispensing outlet is smaller. This improves the responsiveness of the dispensing head with respect to the switching of the pressure.

### Brief Description of Drawings

[Fig. 1]

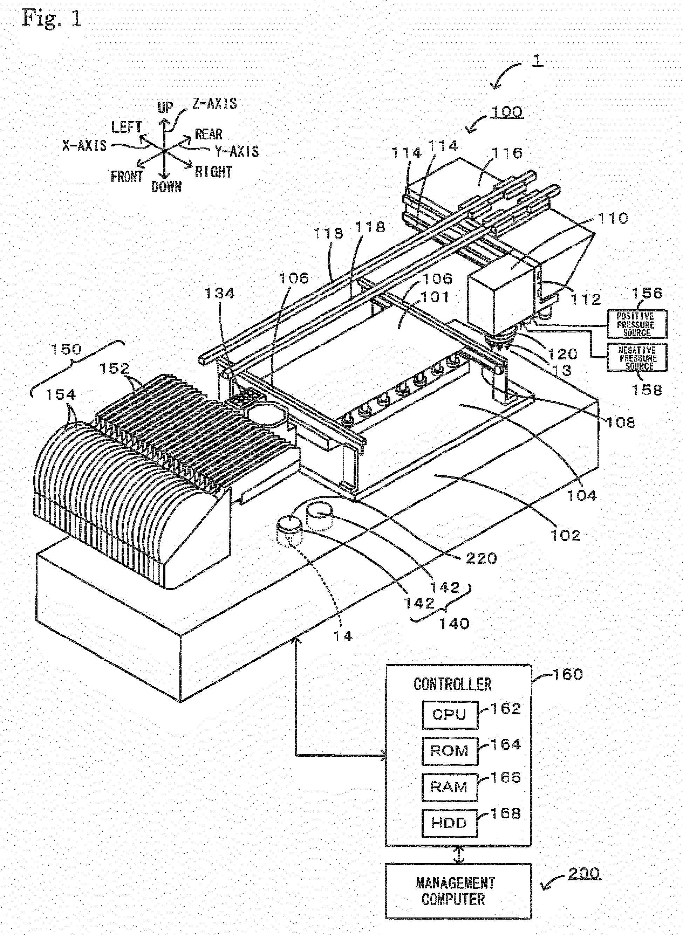

   Fig. 1 shows the overall configuration of component mounting system 1.
[Fig. 2]

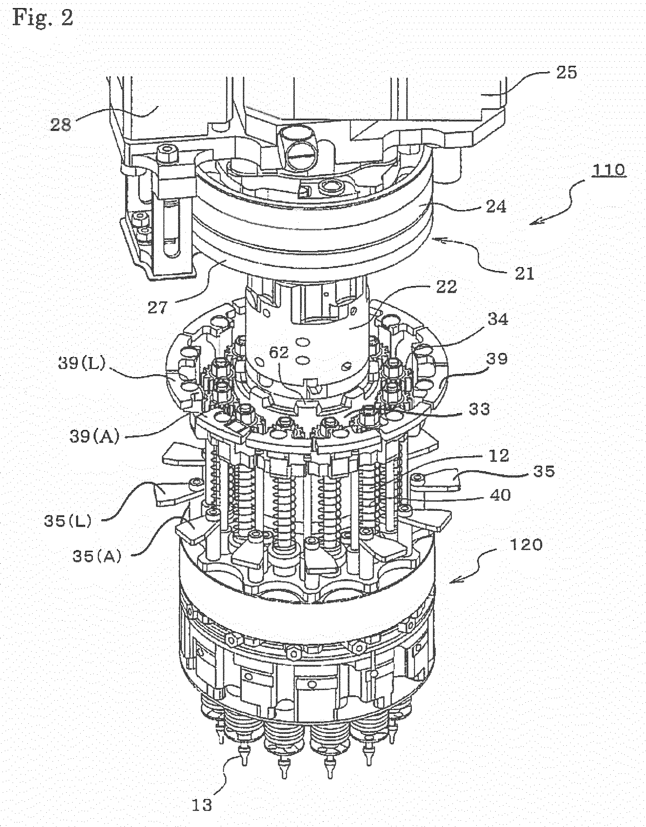

   Fig. 2 is a perspective view of head unit 110.
[Fig. 3]

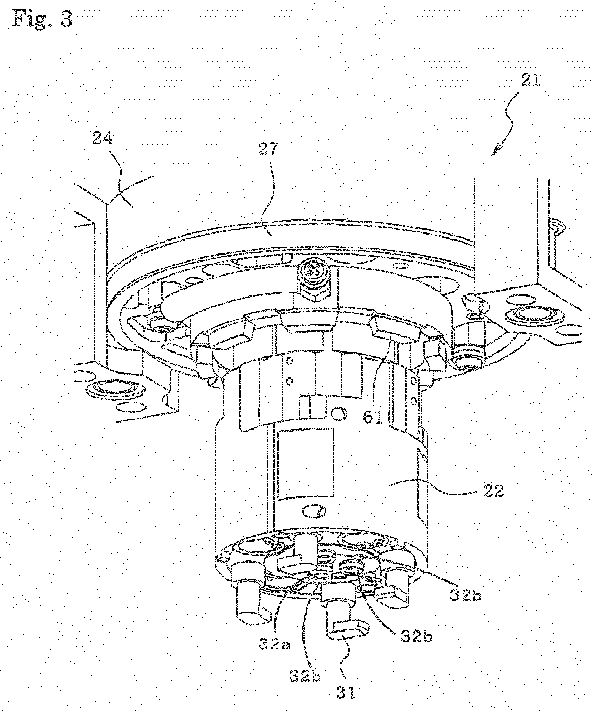

   Fig. 3 is a perspective view of head holding body 21 seen from below looking up diagonally.
[Fig. 4]

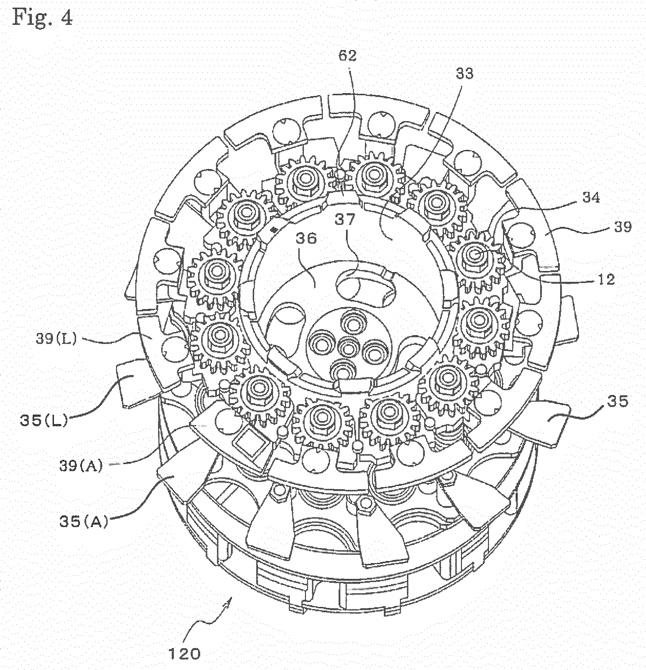

   Fig. 4 is a perspective view of pickup head 120 seen from above looking down diagonally.
[Fig. 5]

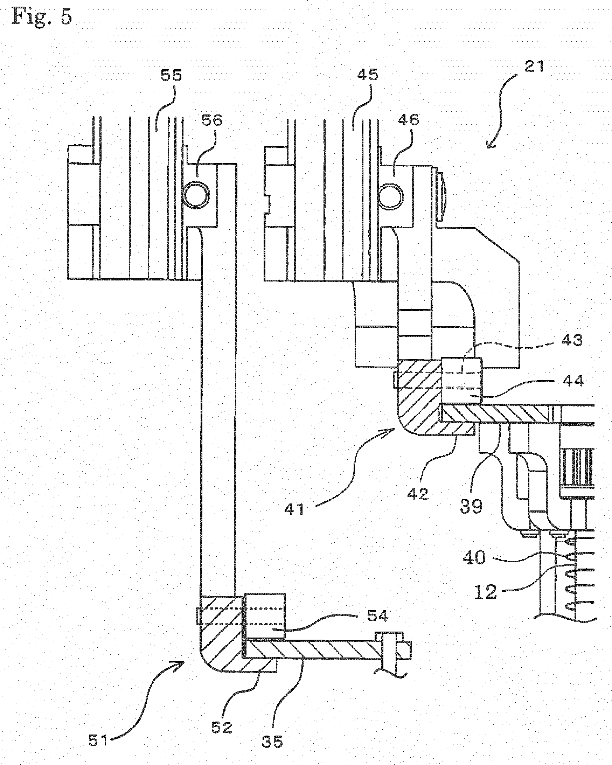

   Fig. 5 is a cross section of a portion surrounding a first and second lever sandwiching section 41 and 51.
[Fig. 6]

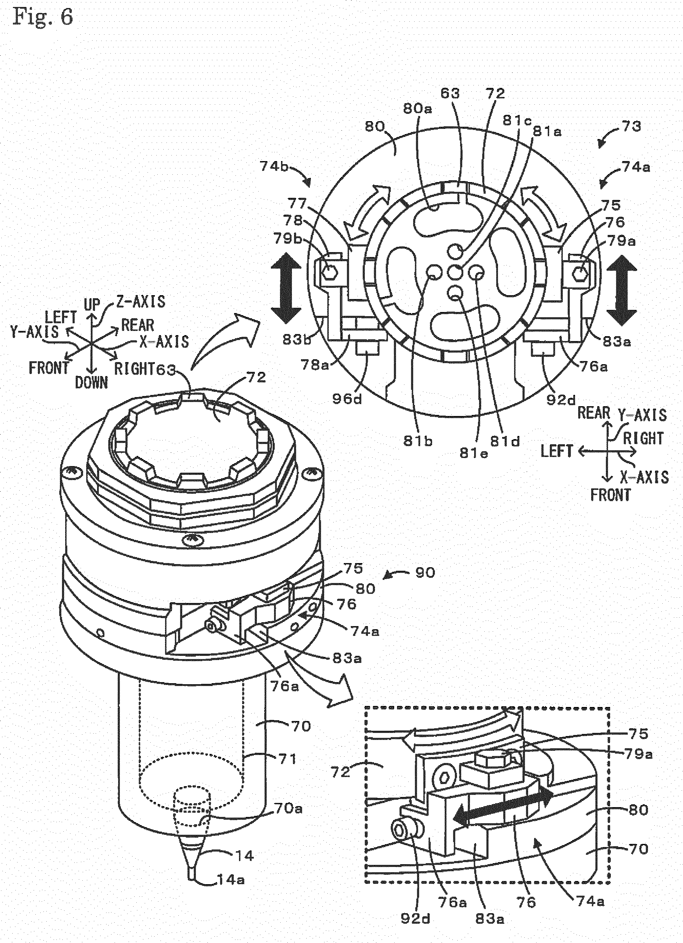

   Fig. 6 is a perspective view of dispensing head 220.
[Fig. 7]

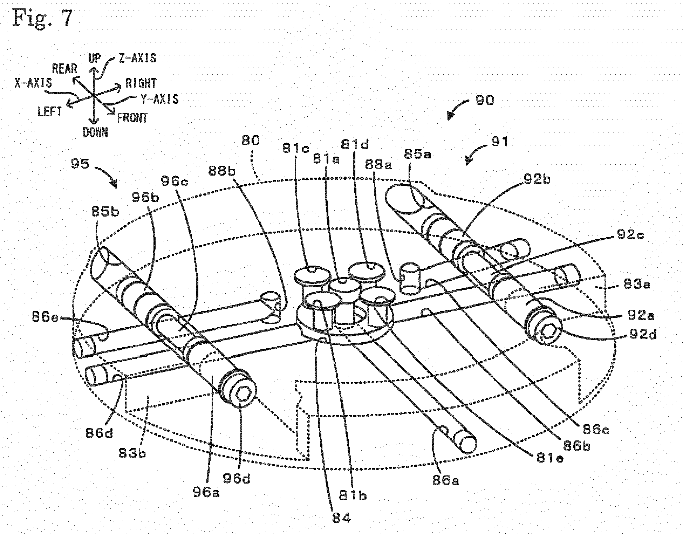

   Fig. 7 is a perspective view of valve mechanism 90 of dispensing head 220.
[Fig. 8]

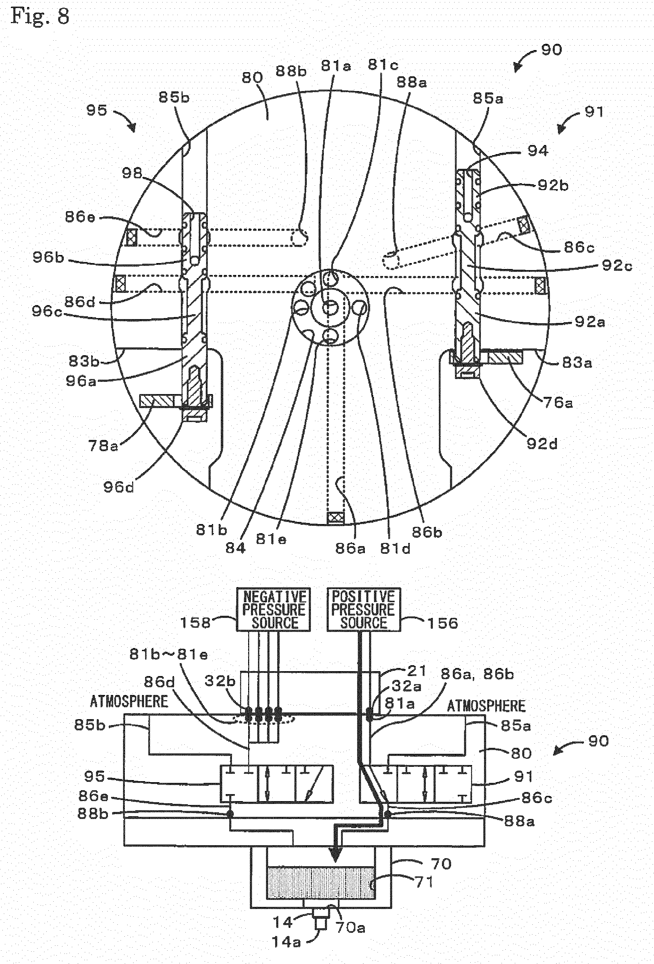

   Fig. 8 shows a first switching state.
[Fig. 9]

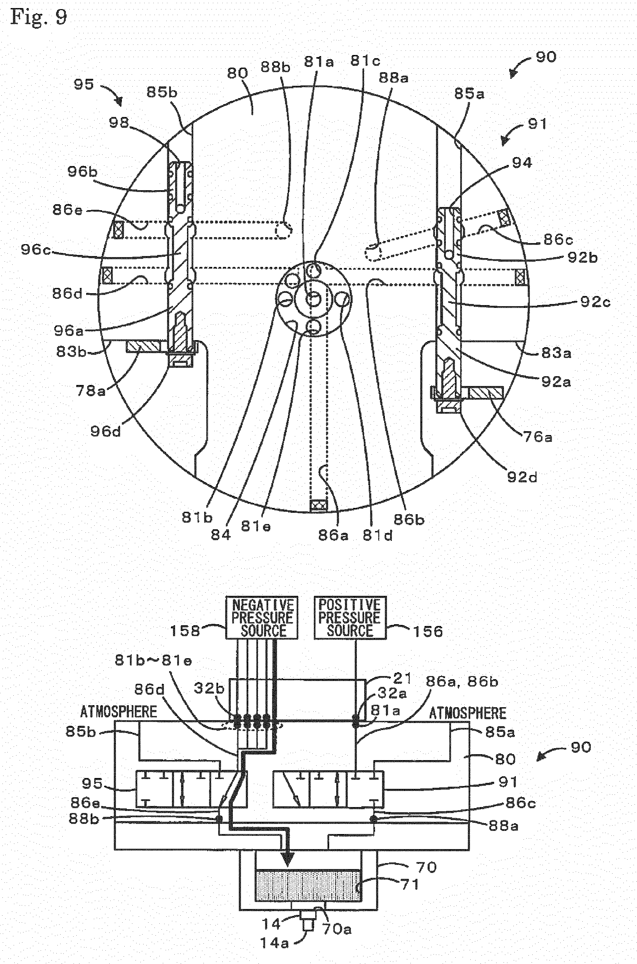

   Fig. 9 shows a second switching state.
[Fig. 10]

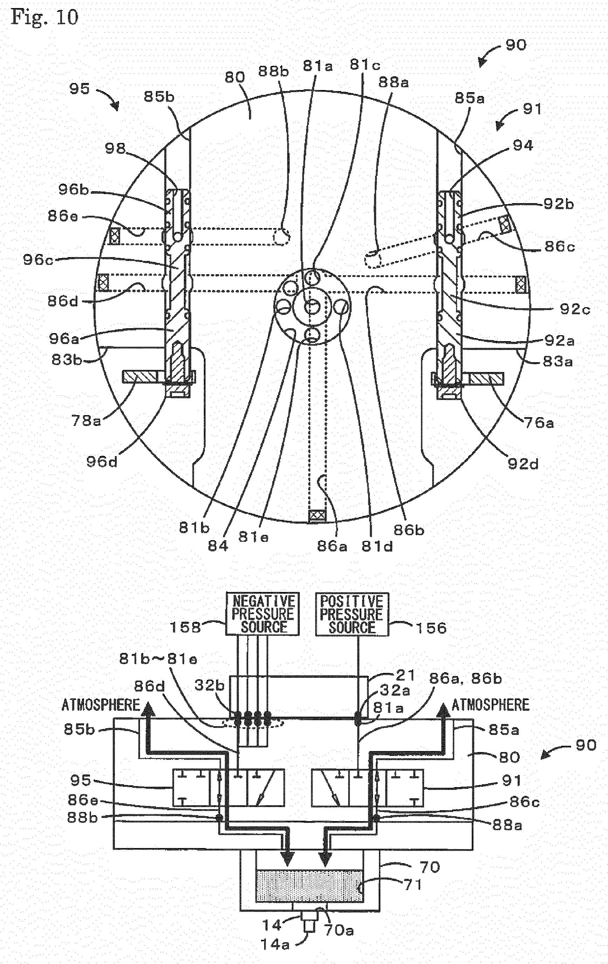

   Fig. 10 shows a third switching state.

### Description of Embodiments

Hereinafter, an embodiment of the present invention will be described with reference to the figures. Fig. 1 shows the overall configuration of component mounting system 1. In the present embodiment, left-right directions (X axis), front-rear directions (Y axis), and up-down directions (Z axis) are set as shown in fig. 1. Component mounting system 1 is provided with component mounting device 100 and management computer 200.

As shown in fig. 1, component mounting device 100 is provided with board conveyance device 104 mounted on base 102, head unit 110 that is capable of movement in an XY plane, pickup head 120 that is detachably attached to head unit 110, head storage area 140 for storing each type of head, component supply device 150 that supplies components to be mounted to board 101, positive pressure source 156 and negative pressure source 158 that respectively supply positive pressure and negative pressure to head unit 110, and controller 160 that performs various types of control.

Board conveyance device 104 conveys board 101 from left to right using conveyor belts 108 and 108 (only one of these is shown in fig. 1) that are respectively attached to a pair of front/rear supporting plates 106 and 106.

Head unit 110 is attached to X-axis slider 112 and moves in a left-right direction with the left-right direction movement of X-axis slider 112 along guide rails 114 and 114, and moves in a front-rear direction with the front-rear movement of Y-axis slider 116 along guide rails 118 and 118. This allows head unit 110 to move in an XY plane. Sliders 112 and 116 are each driven by a servo motor that is not shown in the figures.

Pickup head 120 is detachably attached to head unit 110. Suction nozzle 13 uses pressure to pick up and release a component at the nozzle tip. Twelve pickup nozzles 13 are attached to pickup head 120.

Head storage area 140 is provided on the right side on an upper surface of base 102, and is provided with multiple storage locations 142 for storing dispensing heads 220. A dispensing head 220 is being stored in the storage location at the front; the storage location 142 at the rear is empty.

Dispensing head 220 is detachably attached to head unit 110. One dispensing nozzle 14 is attached to dispensing head 220. Dispensing nozzle 14 is for dispensing adhesive used for attaching a component to board 101 from the outlet at the nozzle tip.

Component supply device 150 is attached to the front of component mounting device 100. Component supply device 150 has multiple slots and a feeder 152 can be inserted into each slot. Reel 154 around which tape is wound is attached to feeder 152. Components are held in the surface of the tape lined up in the lengthwise direction of the tape. The components are protected by a film that covers the surface of the tape. This tape is indexed to the rear by a sprocket mechanism which is not shown and the film is peeled off, such that the components are arranged at a predetermined position in an exposed state. The predetermined position is a position at which the component can be picked up by suction nozzle 13. A suction nozzle 13 that has picked up a component at this predetermined position is capable of mounting that component at a specified position on board 101.

Positive pressure source 156 and negative pressure source 158 are configured from, for example, a pressure pump and a vacuum pump, and are connected to head unit 110 with piping. Positive pressure supplied by positive source 156 is used, for example, as pressure for pushing and dispensing adhesive from dispensing nozzle 14. Negative pressure supplied by negative pressure source 158 is used, for example, as pressure for picking up a component on suction nozzle 13. Also, negative pressure supplied by negative pressure 158 is used as pressure for stopping the dispensing of adhesive from dispensing nozzle 14.

Component mounting device 100 is also provided with nozzle stocker 134 and so on. Nozzle stocker 134 is a box that stocks multiple types of suction nozzles 13 and multiple types of dispensing nozzles 14, and is provided next to component supply device 150. Suction nozzles 13 are exchanged as appropriate for the type of component and type of board on which the component is to be mounted. Dispensing nozzles 14 are exchanged based on the nozzle with a diameter appropriate for the amount of adhesive to be dispensed (the diameter of the adhesive deposit to be applied to board 101).

Controller 160 is provided with CPU 162 that performs various types of control, ROM 164 that memorizes control programs and so on, RAM 166 used as working memory, and HDD 168 that memorizes large amounts of data, and these are connected by a bus which is not shown. Controller 160 is connected to board conveyance device 104, X-axis slider 112, Y-axis slider 116, and head unit 110 so as to be capable of exchanging signals with those items.

Management computer 200 manages the production job of board 101, and memorizes production job data created by an operator. Defined in the production job data is which components from feeders at which slot positions are to be mounted to which type of board 101 and in what order at component mounting device 100, and also how many of those boards 101 are to be manufactured and so on. Also defined in production job data is how much adhesive for attaching each mounted component to board 101 is to be applied, and at which positions on board 101 and in what order, and so on. Management computer 200 is connected to controller 160 of component mounter 100 such that two-way communication is possible.

Head unit 110 is described in detail below. Fig. 2 is a perspective view of head unit 110 with the covers removed, specifically, a perspective view with pickup head 120 lowered with respect to R axis 22 of head holding body 21. Fig. 3 is a perspective view of head holding body 21 seen from below looking up diagonally; fig, 4 is a perspective view of pickup head 120 seen from above looking down diagonally.

Head unit 110 is provided with head holding body 21 and pickup head 120.

Head holding body 21 is attached to X-axis slider 112 (refer to fig. 1) to be capable of being raised/lowered by a raising/lowering mechanism which is not shown. Head holding body 21 has two ring-shaped gears, R-axis gear 24 and Q-axis gear 27, on the upper portion and a cylinder, R-axis 22, on the lower portion. R-axis gear 24 and Q-axis gear 27 are attached so as to rotate independently from each other. R-axis gear 24 is driven by R-axis motor 25 and rotates as one with R axis 22. Q-axis gear 27 is driven by Q-axis motor 28 and rotates as one with ring-shaped clutch member 61 (refer to fig. 3). R axis 22 has multiple (four in this case) engaging members 31 with a hook on the lower end. The direction of the hook is arranged to be the same as the forward rotation direction of R axis 22. These engaging members 31 are arranged at even intervals on the same circular circumference on the lower surface of R axis 22 (the center of the circumference matches the center axis of R axis 22). Also, each engaging member 31 is capable of up/down movement by an air cylinder which is not shown. One positive pressure supply opening 32a and four (only three are shown in fig. 3) negative pressure openings 32b are formed on the lower end of R axis 22. Positive pressure supply opening 32a is formed at a position matching the center axis of R axis 22. Negative pressure openings 32b are arranged inside the circumference on which engaging members 31 are lined up, and are arranged at even intervals on the same circular circumference of the lower surface of R axis 22 so as to surround positive pressure supply opening 32a. Positive pressure supply opening 32a and negative pressure openings 32b are respectively connected to positive pressure source 156 and negative pressure source 158 via the pressure supply passage inside head holding body 21. Head holding body 21 further has first and second lever sandwiching sections 41 and 51, which are shown in fig. 5; these are described later.

Pickup head 120 is a member with an approximately cylindrical exterior, and multiple (in this case, twelve) suction nozzles 13 are on the bottom of pickup head 120. Suction nozzle 13 is formed as one unit with nozzle holder 12, which is provided in a vertical orientation. Nozzle holder 12 has nozzle operation lever 39 near the top end, and is biased upwards by spring 40 such as to be positioned at a specified set position (up position). Nozzle operation levers 39 are provided from first nozzle operation lever 39 (A) to last (twelfth) nozzle operation lever 39 (L) in order of suction nozzles 13 to be operated. When looking from above in fig. 2, this order is counterclockwise from the first to the last. When nozzle operation lever 39 is pressed, nozzle holder 12 and suction nozzle 13 are lowered against the elastic force of spring 40; when nozzle operation lever 39 is released, nozzle holder 12 and suction nozzle 13 return to the set position by the elastic force of spring 40. Nozzle holder 12 engages with small gear 34 that is arranged to have the same axis as nozzle holder 12. Each small gear 34 is arranged at even intervals on the same circular circumference (the center of this circle matches the center axis of R axis 22). Cylinder gear 33 is arranged inside the circle on which small gears 34 are lined up, has teeth on the side surface, and engages with each small gear 34. Also, cylinder gear 33 is designed with dimensions such that it can be inserted into R axis 22. Clutch member 62 that engages with clutch member 61 (refer to fig. 3) of head holding body 21 is provided on the upper end of cylinder gear 33.

Also, pickup head 120, for each suction nozzle 13, has pressure operation lever 35 that switches to and from supplying negative pressure to the nozzle tip or supplying atmospheric pressure to the nozzle tip. Pressure operation lever 35 is a switch without a return function; when in the upper position negative pressure is supplied to the nozzle tip, when in the lower position, atmospheric pressure is supplied to the nozzle tip. Pressure operation levers 35 are also provided from first pressure operation lever 35 (A) to last (twelfth) pressure operation lever 35 (L) in order of suction nozzles 13 to be operated.

Further, pickup head 120 has circular plate-shaped base 36 (refer to fig. 4) inside cylinder gear 33. Base 36 is one unit with a support member that supports nozzle holders 12 and small gears 34, but is not one unit with cylinder gear 33. Thus, cylinder gear 33 is capable of rotating independently from base 36. Arc-shaped engaging holes 37 are formed in base 36 so as to be engageable with the hook of engaging member 31 of R axis 22.

Returning to the description of head holding body 21. Fig. 5 is a cross section of a portion surrounding a first and second lever sandwiching section 41 and 51. As shown in fig. 5, lever sandwiching section 41 of head holding body 21 is attached to first Z-axis slider 46 that is movable in an up/down direction along first Z-axis guide rail 45 provided on head holding body 21. Note that, first Z-axis slider 46 is driven by a servo motor, which is not shown. First lever sandwiching section 41 sandwiches nozzle operation lever 39 from above and below with L-shaped member horizontal portion 42 and roller 44 attached above horizontal portion 42. Roller 44 is rotatably supported on horizontal axis 43.

Head holding body 21 has second lever sandwiching section 51. Due to the fact that pressure operation lever 35 is positioned further to the outside radially than nozzle operation lever 39, second lever sandwiching section 51 is positioned further to the outside radially then first lever sandwiching section 41. In a similar way to first lever sandwiching section 41, second lever sandwiching section 51 is attached to second Z-axis slider 56 that is movable in an up/down direction along second Z-axis guide rail 55 provided on head holding body 21. Note that, second Z-axis slider 56 is driven by a servo motor, which is not shown. Second lever sandwiching section 51 sandwiches pressure operation lever 35 from above and below with L-shaped member horizontal portion 52 and roller 54 attached above horizontal portion 52.

Next, dispensing head 220 is described. Fig. 6 is a perspective view of dispensing head 220. Fig. 7 is a perspective view of valve mechanism 90 of dispensing head 220. Note that, the top right diagram of fig. 6 shows dispensing head 220 from above, and shows switching section 73 in a transparent state. The bottom right diagram of fig. 6 is a perspective view of first switching section 74a. Fig. 7 shows valve mechanism 90 with the inside of base 80 in a transparent state. Dispensing head 220 is a member with an approximately cylindrical exterior, and is provided with main body section 70 that is internally equipped with housing chamber 71 which houses adhesive, valve mechanism 90 that is equipped with base 80 which is attached to the upper side of main body section 70, cylinder gear 72 attached to the upper side of base 80, and switching section 73 attached on the outer circumference of cylinder gear 72. Main body section 70 is formed with a circular plate-shaped member and a cylindrical member with a diameter smaller than the circular plate-shaped member connected to the same axis, and one dispensing nozzle 14 is provided on the lower section of the cylindrical member. Main body lower opening 70a connected to housing chamber 71 is formed on the lower section of main body section 70. Dispensing nozzle 14 is provided with dispensing outlet 14a at the tip, and is attached to main body section 70 such that main body lowering opening 70a and dispensing outlet 14a are connected.

Cylinder gear 72 is a similar member to cylinder gear 33 of pickup head 120. Cylinder gear 72 is designed with dimensions such that it can be inserted into R axis 22. Clutch member 63 that engages with clutch member 61 (refer to fig. 3) of head holding body 21 and that can receive operation (rotation) from clutch member 61 is provided on the upper end of cylinder gear 72. Clutch member 63 is exposed at a connection surface (the upper surface of fig. 6) with head holding body 21 when dispensing head 220 is held by head holding body 21. Cylinder gear 72 is not one unit with base 80 and can rotate independently from base 80.

Switching section 73 is a mechanism that switches valve mechanism 90 according to the rotation of cylinder gear 72. As shown in the top right of fig. 6, switching section 73 is provided with first switching section 74a and second switching section 74b. First and second switching sections 74a and 74b move respective first and second valve bodies 91 and 95 (refer to fig. 7) of valve mechanism 90 forwards/backwards, so as to perform switching to and from the first to third switching states. Note that, the first switching state is a state in which positive pressure can be supplied to dispensing nozzle 14 via housing chamber 71; the second switching state is a state in which negative pressure can be supplied to dispensing nozzle 14 via housing chamber 71; and the third switching state is a state in which housing chamber 71 and dispensing nozzle 14 are able to be open to the atmosphere. First switching section 74a is provided with first connection member 75 that is fixed to the outer circumferential surface of cylinder gear 72, and second connection member 76 that is connected to first connection member 75 via pin 79a which is fixed to first connection member 75. Second connection member 76 is provided with plate section 76a fixedly connected to first valve body 91 (refer to fig. 7) by bolt 92d. Second switching section 74b is provided with third connection member 77 that is fixed to the outer circumferential surface of cylinder gear 72, and fourth connection member 78 that is connected to third connection member 77 via pin 79b which is fixed to third connection member 77. Fourth connection member 78 is provided with plate section 78a fixedly connected to second valve body 92 (refer to fig. 7) by bolt 96d.

With this switching section 73, when cylinder gear 72 rotates, first connection member 75 and third connection member 77 respectively move in the circumferential direction of cylinder gear 72 (refer to the white-bodied arrows in fig. 6). When first connection member 75 and third connection member 77 move, based on this movement, second connection member 76 and fourth connection member 78 move in a straight line (refer to the black-bodied arrows in fig. 6) in a specified direction (forward/back in the present embodiment), such that first valve body and second valve body 95 move in a straight line forward/back. Thus, switching section 73 is a mechanism that converts rotational movement of cylinder gear 72 into straight line movement and transmits it valve mechanism 90. Note that, the holes into which pin 79a and pin 79b out of second connection member and fourth connection member 78 are inserted into are formed with a shape longer in the diameter direction than in the circumferential direction (for example, a rectangle with rounded corners with the long side in the diameter direction). By this, when first connection member 75 and third connection member 77 move in the circumference direction of cylinder gear 72, the straight line movement of second connection member 76 and fourth connection member 78 is not obstructed.

As shown in fig. 7, valve mechanism 90 is provided with base 80 in which are formed multiple holes, first valve body 91 that is movable forwards/backwards inside base 80, and second valve body 95 that is movable backwards/forwards inside base 80.

As shown in fig. 6, base 80 is a member that is approximately a circular plate, and formed therein are multiple (four in the present embodiment) engaging holes 80a and first to fifth upper openings 81a to 81e. Engaging hole 80a is formed in the same shape as engaging hole 37 of pickup 120 (refer to fig. 4), and is formed to be engagable with the hook of engaging member 31 of R axis 22. First upper opening 81a is formed to be connectable with positive pressure supply opening 32a (refer to fig. 3) of head holding body 21 when dispensing head 220 is held in head holding body 21; second to fifth upper openings 81b to 81e are formed to be connectable in a one-to-one manner with negative pressure openings 32b (refer to fig. 3) of head holding body 21 when dispensing head 220 is held on head holding body 21. Also, first step section 83a is formed in the front right side of base 80, and second step section 83b is formed in the front left side of base 80.

As shown in fig. 7, ring-shaped passage 84 that connects with a long hole formed from the bottom of each of second to fifth upper openings 81b to 81e, first through-hole 85a that runs in the front/rear direction from first step section 83a to the side surface of the rear side of base 80, and second through-hole 85b that runs in the front/rear direction from second step section 83b to the side surface of the rear side of base 80, are provided in base 80. Also, first sideways hole 86a connected to first upper opening 81a, second sideways hole 86b connected to first sideways hole 86a and first through-hole 85a, third sideways hole 86c connected to first through-hole 85a, and first lengthwise hole 88a that is connected to third sideways hole 86c and opens onto the lower surface of base 80, are formed in base 80. Also, fourth sideways hole 86d connected to ring-shaped passage 84 and second through-hole 85b, fifth sideways hole 86e connected to second through-hole 85b, and second lengthwise hole 88b that is connected to fifth sideways hole 86e and opens onto the lower surface of base 80, are formed in base 80. Note that, a long hole is formed running up/down in the center of ring-shaped passage 84 from first upper opening 81a to first sideways hole 86a; first sideways hole 86a and ring-shaped passage 84 are not connected. First and second lengthwise holes 88a and 88b connect to an upper portion of housing chamber 71 via lengthwise holes, which are not shown, formed in main body section 70. The openings formed in the side surface of base 80 for first to fifth sideways holes 86a to 86e are each blocked with sealing material.

First valve body 91 is a member that moves forward/backward inside first through-hole 85a to switch to and from a state in which second sideways hole 86b and third sideways hole 86c are connected and a state in which they are not connected. First valve body 91 is formed as a cylindrical rod, and is provided with first cylinder section 92a, second cylinder section 92b, and small-diameter cylinder section 92c that is thinner than first cylinder section 92a and second cylinder section 92b. The front end of first cylinder section 92a protrudes from the opening of the first step section 83a side of first through-hole 85a, and by bolt 92d that is inserted into the front end of first cylinder section 92a, first cylinder section 92a and plate section 76a of second connection member 76 are fixedly connected (refer to fig. 8, which is described later). Also, atmosphere connecting hole 94 that connects a hole formed from the rear end of second cylinder section 92b in the axial direction and a hole formed from the side surface of second cylinder section 92b facing the center axis thereof, are formed in second cylinder section 92b (refer to fig. 8, which is described later). Atmosphere connecting hole 94 connects the space outside second cylinder section 92b of first through-hole 85a and the opening in the rear side of base 80. First cylinder section 92a and second cylinder section 92b are each provided with at least one (in the present embodiment, first cylinder section 92a has one and second cylinder section 92b has three) O-ring, such that the gap between the outer circumferential surface of first valve body 91 and first through-hole 85a is sealed.

Second valve body 95 is a member that moves forward/backward inside second through-hole 85b to switch to and from a state in which fourth sideways hole 86d and fifth sideways hole 86e are connected and a state in which they are not connected. Second valve body 95 is formed as a cylindrical rod, and is provided with first cylinder section 96a, second cylinder section 96b, and small-diameter cylinder section 96c that is thinner than first cylinder section 96a and second cylinder section 96b. The front end of first cylinder section 96a protrudes from the opening of the first step section 83b side of second through-hole 85b, and by bolt 96d that is inserted into the front end of first cylinder section 96a, first cylinder section 96a and plate section 78a of fourth connection member 78 are fixedly connected (refer to fig. 8, which is described later). Also, atmosphere connecting hole 98 that connects a hole formed from the rear end of second cylinder section 96b in the axial direction and a hole formed from the side surface of second cylinder section 96b facing the center axis thereof, are formed in second cylinder section 96b (refer to fig. 8, which is described later). Atmosphere connecting hole 98 connects the space outside second cylinder section 96b of first through-hole 85b and the opening in the rear side of base 80. First cylinder section 96a and second cylinder section 96b are each provided with at least one (in the present embodiment, first cylinder section 96a has one and second cylinder section 96b has three) O-ring, such that the gap between the outer circumferential surface of second valve body 95 and second through-hole 85b is sealed.

Valve mechanism 90 operation is described below. Valve mechanism 90 is able to switch to and from first to third switching states by the forward/backward movement of first valve body 91 and second valve body 95 using cylinder gear 72 and switching section 73. Figs. 8 to 10 respectively show the first switching state, second switching state, and third switching state. In figs. 8 to 11, the upper diagram shows valve mechanism 90 as seen from above, and the lower diagram shows a conceptual view of the pressure supply state.

As shown in the upper diagram of fig. 8, in the first switching state, plate section 76a of second connection member 76 is in a state rotated to the left when viewing cylinder gear 72 from above such that plate section 76a contacts first step section 83a. In the first switching state, small-diameter cylinder section 92c of first valve body 91 is positioned to straddle between second sideways hole 86b and third sideways hole 86c as viewed from above. By this, second sideways hole 86b and third sideways hole 86c are connected via first through-hole 85a. Thus, first upper opening 81a and first sideways hole 86a, second sideways hole 86b, first through-hole 85a, third sideways hole 86c, and first lengthwise hole 88a are connected in that order. Thus, as shown in the lower diagram of fig. 8, when dispensing head 220 is held by head holding section 21, it is possible to supply positive pressure to housing chamber 71 and dispensing nozzle 14 from positive pressure source 156. Conversely, for second valve body 95, the connection between fourth sideways hole 86d and fifth sideways hole 86e via second through-hole 85b is sealed by second cylinder section 96b, and negative pressure is not supplied from negative pressure source 158 to fifth sideways hole 86e (and thus is not supplied housing chamber 71 and dispensing nozzle 14, which are beyond fifth sideways hole 86e).

As shown in the upper diagram of fig. 9, in the second switching state, plate section 78a of fourth connection member 78 is in a state rotated to the left when viewing cylinder gear 72 from above such that plate section 78a contacts second step section 83b. In the second switching state, small-diameter cylinder section 96c of second valve body 95 is positioned to straddle between fourth sideways hole 86d and fifth sideways hole 86e as viewed from above. By this, fourth sideways hole 86d and fifth sideways hole 86e are connected via second through-hole 85b. Second to fifth upper openings 81b to 81e, ring-shaped passage 84, fourth sideways hole 86d, second through-hole 85b, fifth sideways hole 86e, and second lengthwise hole 88b are connected in that order. Thus, as shown in the lower diagram of fig. 9, when dispensing head 220 is held by head holding section 21, it is possible to supply negative pressure to housing chamber 71 and dispensing nozzle 14 from negative pressure source 158. Conversely, for first valve body 91, the connection between second sideways hole 86b and third sideways hole 86c via first through-hole 85a is sealed by second cylinder section 92b, and positive pressure is not supplied from positive pressure source 156 to third sideways hole 86c (and thus is not supplied housing chamber 71 and dispensing nozzle 14, which are beyond third sideways hole 86c).

As shown in the upper diagram of fig. 10, in the third switching state, the rotational position of cylinder gear 72 is between that of the first switching state and the second switching state, and plate sections 76a and 78a of second and fourth connection members 76 and 78 are in a state separately from first and second step sections 83a and 83b respectively. In the third switching state, the opening formed in the outer circumferential surface of atmosphere connecting hole 94 of first valve body 91 is positioned at the section connected to third sideways hole 86c of first through-hole 85a. By this, third sideways hole 86c is connected to the opening on the rear side of first through-hole 85a via atmosphere connecting hole 94 so as to be open to the atmosphere. In a similar way, fifth sideways hole 86e is connected to the opening on the rear side of second through-hole 85b via atmosphere connecting hole 98 of second valve body 95 so as to be open to the atmosphere. By this, as shown in the lower diagram of fig. 10, housing chamber 71 and dispensing nozzle 14 connected to third sideways hole 86c and fifth sideways hole 86e are open to the atmosphere.

Note that, in each of the first to third switching states, the O-rings of first valve body 91 and second valve body 95 prevent gas (pressure) leaking outside from first and second through-holes 85a and 85b.

In component mounting system 1 configured as given above, CPU 162 of controller 160 of component mounting device 100 performs mounting processing using head unit 110 based on production job data received from management computer 200. In the mounting processing, CPU 162 performs each of adhesive application processing for applying a specified amount of adhesive to a specified position on board 101, and component mounting processing for mounting a component to the position at which adhesive was applied on board 101, multiple times. Also, CPU 162, when starting adhesive application processing and component mounting processing, in cases in which a head appropriate for the processing to be performed is not held by head holding body 21, performs head automatic exchange processing. Adhesive application processing, component mounting processing, and head automatic exchange processing are each described below.

In adhesive application processing, first, CPU 162, with head holding body 21 holding dispensing head 220, moves head unit 110 to a specified position above board 101 based on production job data received from management computer 200. During movement of dispensing head 220, CPU 162 adjusts the rotational position of cylinder gear 72 such that valve mechanism 90 is in the third switching state, so as to open housing chamber 71 and dispensing nozzle 14 to the atmosphere. CPU 162 rotates cylinder gear 72 by rotating Q-axis gear 27 and clutch member 61 using Q-axis motor 28. Also, the viscosity of adhesive housed in housing chamber 71 is adjusted in advance so that the adhesive is not dispensed from dispensing outlet 14a when dispensing nozzle 14a is open to the atmosphere. Continuing, CPU 162 rotates cylinder gear 72 counterclockwise using Q-axis motor 28 to switch valve mechanism 90 from the third switching state to the first switching state. By this, positive pressure is supplied to dispensing nozzle 14 such that adhesive is dispensed from dispensing outlet 14a and applied on board 101. CPU 162, after having maintained the first switching state for a specified period of time based on the amount of adhesive to be applied, rotates cylinder gear 72 clockwise using Q-axis motor 28 to switch valve mechanism 90 to the second switching state. By this, negative pressure is supplied to dispensing nozzle 14 such that adhesive stops being dispensed from dispensing outlet 14a. After that, CPU 162 returns valve mechanism 90 to the third switching state. In this way, CPU 162 rotates cylinder gear 72 by rotating clutch member 61, thus operating valve mechanism 90 provided in dispensing head 220, thereby performing switching of the pressure. When starting adhesive application processing, CPU 162 moves dispensing head 220 above the appropriate nozzle stocker 134 and performs changing of dispensing nozzle 14 based on the production job data such that the appropriate type of dispensing nozzle 14 is attached to dispensing head 220.

Component mounting processing is described next. In component mounting processing, first, CPU 162 picks up a component using suction nozzle 13 of pickup head 120. Specifically, first, CPU 162 moves head unit 110 and moves the first suction nozzle 13 to the specified position at which to pick up a component from component supply device 150. Next, CPU 162 performs processing to pick up at least one component. Specifically, CPU 162 presses nozzle operation lever 39 using first lever sandwiching section 41 so as to lower suction nozzle 13. In that state, CPU 162 positions pressure operation lever 35 in the upper position using second lever sandwiching section 51 to supply negative pressure to the tip of suction nozzle 13 from negative pressure source 158 such that the component is picked up. Next, the pressing of nozzle operation lever 39 is released such that suction nozzle 13 is raised. When picking up two or more components, similar operations are repeated and components are picked up by multiple suction nozzles 13. When component pickup is complete, CPU 162 moves the suction nozzle 13 holding the component to be mounted to above the mounting position for the component. Then, CPU 162 presses nozzle operation lever 39 such that suction nozzle 13 is lowered, turns off the negative pressure supplied to suction nozzle 13 so as to mount the component on board 101. After that, suction nozzle 13 is raised. When multiple suction nozzles 13 have picked up components, CPU 162 repeatedly performs the above operations to mount one component on board 101 so as to mount the components picked up by suctions nozzles 13 of pickup head 120 sequentially on board 101. When all the components picked up by suction nozzles 13 have been mounted on board 101, component mounting processing ends. Note that, when mounting components picked up by suction nozzles 13, CPU 162 appropriately corrects the direction (angle) of the components held on suction nozzles 13. Specifically, CPU 162 rotates clutch member 61, clutch member 62, small gear 34, and nozzle holder 12 by rotating Q-axis gear 27 such that suction nozzle 13 is rotated. When starting component mounting processing, CPU 162 moves pickup head 120 above the appropriate nozzle stocker 134 and performs changing of suction nozzle 13 based on the production job data such that the appropriate type of suction nozzle 13 is attached to pickup head 120. CPU 162 presses nozzle operation levers 39 one by one such that suction nozzles 13 are lowered one by one, thus performing changing of suction nozzles 13.

Head automatic exchange processing is described next. In head automatic exchange processing, first, CPU 162 moves head unit 110 directly above an empty storage location 142 in storage area 140, lowers head holding body 21, and stores the head currently held by head holding body 21 in the empty storage location 142. Continuing, CPU 162, after removing the hook of engaging members 31 from the engaging holes of the held head (engaging holes 37 or engaging holes 80a), raises head holding body 21. Next, CPU 162 moves head unit 110 directly above storage location 142 of the exchange target head. Then, CPU 162 lowers head holding body 21, and engages engaging members 31 with the engaging holes (engaging holes 37 or engaging holes 80a) of the exchange target head to complete head automatic exchange processing. By this, the exchange target head is held by head holding body 21. In this way, CPU 162 exchanges the head being held by head holding body 21 to one or the other of pickup head 120 and dispensing head 220.

Correspondences between constituent elements of the present embodiment and constituent elements of the invention will be clarified here. Component mounting device 100 of the present embodiment corresponds to the board work device of the present invention; housing chamber 71 corresponds to the viscous fluid housing chamber; dispensing outlet 14a corresponds to the viscous fluid dispensing outlet; the first switching state corresponds to the first state; the second switching state corresponds to the second state; valve mechanism 90 corresponds to the valve mechanism; cylinder gear 72 corresponds to the operation entry section; switching section 73 corresponds to the switching section; dispensing head 220 corresponds to the dispensing head; and head holding body 21 corresponds to the head holding means. Also, pickup head 120 corresponds to the mounting head; clutch member 61 corresponds to the operation section; suction nozzle 13 corresponds to the component holding tool; clutch member 62, small gear 34, and nozzle holder 12 correspond to the axis rotating mechanism; first upper opening 81a corresponds to the first opening; second to fifth upper openings 81b to 81e correspond to the second opening; positive pressure supply outlet 32a corresponds to the first supply outlet, negative pressure supply outlet 32b corresponds to the second supply outlet, and the third switching state corresponds to the third state. Note that, in a state in which dispensing nozzle 14 is not attached to dispensing head 220, the main body lower opening 70a corresponds to the viscous fluid dispensing outlet.

With component mounting device 100 of the present embodiment as described above, dispensing head 220 is provided with valve mechanism 90 that is capable of switching to a first switching state in which adhesive at dispensing outlet 14a is pushed and dispensed via the housing chamber 71 and a second switching state in which the adhesive cannot be dispensed. Also, when cylinder gear 72 enters an operation from an external section, switching section 73 switches valve mechanism 90 based on the entered operation. In this way, by valve mechanism 90 provided in dispensing head 220, dispensing head 220 is capable of switching to and from a state in which dispensing head 220 can dispense and a state in which dispensing head 220 cannot dispense, that is, it is capable of switching the pressure. Thus, compared to a case, for example, in which valve mechanism 90 is provided on head holding body 21 that holds dispensing head 220, the distance from the point at which the pressure changes due to the switching of valve mechanism 90 to dispensing outlet 14a is smaller. This improves the responsiveness of dispensing head 220 with respect to the switching of the pressure.

Also, head holding body 21 exchangeably holds dispensing head 220 or pickup head 120, and has clutch member 61 that operates the held pickup head 120. Also, cylinder gear 72 is capable of having operation from clutch member 61 inputted. Thus, clutch member 61 of head holding body 21 is able to be shared for operation of pickup head 120 and operation of dispensing head 220. By this, compared to a case in which, for example, head holding body 21 is provided with an operation section for dispensing head 220 use that is not used for operation of pickup head 120, the configuration of head holding body 21 is simpler. Also, head holding body 21 created for exchangeably holding dispensing head 220 can be used for holding dispensing head 220 without providing a new operation section.

Further, clutch member 61 of head holding body 21 is able to perform operation of clutch member 62, small gear 34, and nozzle holder 12 that axially rotate suction nozzle 13 of pickup head 120, and is able to perform operation of cylinder gear 72 of dispensing head 220. With dispensing head 220, because there is no need to axially rotate suction nozzle 13, there is great significance to being able to operate cylinder gear 72 of dispensing head 220 with clutch member 61 that is the operation section that axially rotates suction nozzle 13 of pickup head 120.

Further, cylinder gear 72 is exposed at a connection surface with head holding body 21 when dispensing head 220 is held by head holding body 21. Thus, when dispensing head 220 is held by head holding body 21, because cylinder gear 72 contacts head holding body 21, it becomes easier to operate cylinder gear 72 from the head holding body 21 side.

Further, valve mechanism 90 is switchable to a first switching state in which dispensing outlet 14a is connected to first upper opening 81a via housing chamber 71 and not connected to second to fifth upper openings 81b to 81e, and to a second switching state in which dispensing outlet 14a is connected to second to fifth upper openings 81b to 81e via housing chamber 71 and not connected to first upper opening 81a. Thus, by switching such that housing chamber 71 is connected to either first upper opening 81a or second to fifth upper openings 81b to 81e, it is possible to perform switching of the pressure. Further, valve mechanism 90 is also switchable to a third switching state in which dispensing outlet 14a is connected to the atmosphere via housing chamber 71, thus making dispensing outlet 14a open to the atmosphere. Here, if, for example, valve mechanism 90 is left in the second switching state during a period when dispensing is not performed, such as during movement of dispensing head 220, adhesive inside dispensing nozzle 14 may return excessively to the housing chamber 71 side, such that the time from subsequently switching to the first switching state until adhesive is dispensed is increased. CPU 162, by causing valve mechanism 90 to be in the third switching state during movement of dispensing head 220, curtails this increase in time until dispensing.

Meanwhile, it goes without saying that the invention is not limited to the above-mentioned embodiment and various embodiments may be applied within the technical scope of the invention.

For example, in the embodiment, valve mechanism 90 is switched using clutch member 61 that axially rotates suction nozzle 13, but embodiments are not limited to this. For example, valve mechanism 90 may be switched using first lever sandwiching section 41 or second lever sandwiching section 51. In this case, instead of cylinder gear 72, a lever such as pressure operation lever 75 or nozzle operation lever 39 may be provided on the outer circumferential surface of dispensing head 220, and this lever may be switched with the lever sandwiching section.

In the above embodiment, valve mechanism 90 is provided with first valve body 91 and second valve body 95, but without being limited to this, pressure switching may be performed with any type of mechanism. For example, the mechanism is not limited to a mechanical mechanism, and pressure switching may be performed with a valve mechanism that operates based on electrical operation of an electromagnetic valve. Also, valve mechanism 90 may be switchable to at least two states of a first state in which adhesive of dispensing outlet 14a is pressed and dispensed, and a second state in which adhesive is not dispensed. For example, valve mechanism 90 may be switchable to two states, that of the first switching state and the second switching state, without be switchable to the third switching state. In other cases, valve mechanism 90 may be switchable to two states, that of the first switching state and the third switching state, without be switchable to the second switching state. In this case, the third switching state (a state in which dispensing outlet 14a is connected to the atmosphere via housing chamber 71), corresponds to the "second state in which adhesive is not dispensed".

In the above embodiment, cylinder gear 72 is operated by the rotation of clutch member 61 at head holding body 21 to switch valve mechanism 90, but this is not limited to the rotation of clutch member 61, valve mechanism 90 may be switched by any mechanical operation. Also, this is not limited to mechanical operation, valve mechanism 90 may be switched by any kind of operation, for example, valve mechanism 90 may be switched by entering an electrical operation into dispensing head 220 from head holding body 21.

In the above embodiment, the pressure applied to dispensing outlet 14a is switched by switching to supplying positive pressure to housing chamber 71, supplying negative pressure to housing chamber 71, or opening housing chamber 71 to the atmosphere, but embodiments are not limited to this. For example, the pressure applied to dispensing outlet 14a may be switched by creating/removing a through passage for adhesive between housing chamber 71 and dispensing outlet 14a, for example, between housing chamber 71 and main body lower opening 70a, by opening/closing a valve.

In the above embodiment, suction nozzles 13 of pickup head 120, and dispensing nozzle 14 of dispensing head 220 are detachable, but at least one of suction nozzle 13 and dispensing nozzle 14 may be attached to the head in a non-detachable manner.

In the above embodiment, dispensing head 220 dispenses adhesive, but embodiments are not limited to adhesive, and viscous fluids such as solder or brazing material may be dispensed. Also, suction nozzles 13 of pickup head 120 pick up components using suction, but embodiments are not limited to pickup by suction, so long as pickup head 120 picks up components. For example, pickup head 120 may hold components with a gripping section. Also, component mounting device 100 is provided with one each of a pickup head 120 and a dispensing head 220, but multiple types (for example, types with different quantities of nozzles) of pickup head 120 and dispensing head 220 may be provided. Also, component mounting device 100 may only be provided with dispensing head 220, without being provided with pickup head 120. In this case, head holding body 21 need only be capable of holding dispensing head 220, head holding body 21 need not be capable of holding pickup head 120. Also, in a case in which component mounting device 100 is provided with pickup head 120 and dispensing head 220, head holding body 21 need only be capable of holding one out of pickup head 120 and dispensing head 220, a head holding body that holds the other head may be provided separately on component mounting device 100.

### Industrial Applicability

The present invention may be used in the technical field of board work devices that perform actions such as applying viscous fluids and mounting components on a board.

### Reference Signs List

1: component mounting system; 12: nozzle holder; 13: suction nozzle; 14: dispensing nozzle; 14a: dispensing outlet; 21: head holding body; 22: R axis; 24: R-axis gear; 25: R-axis motor; 27: Q-axis gear; 28: Q-axis motor; 31: engaging member; 32a: positive pressure supply opening; 32b: negative pressure supply opening; 33: cylinder gear; 34: small gear; 35: pressure operation lever; 36: base; 37: engaging hole; 39: nozzle operation lever; 40: spring; 41: first lever sandwiching section; 42: horizontal portion; 43: horizontal axis; 44: roller; 45: first Z-axis guide rail; 46: first Z-axis slider; 51: second lever sandwiching section; 52: horizontal portion; 54: roller; 55: second Z-axis guide rail; 56: second Z-axis slider; 61: clutch member; 62: clutch member; 63: clutch member; 70: main body section; 70a: main body lower opening; 71: housing chamber; 72: cylinder gear; 73: switching section; 74a, 74b: first, second switching sections; 75: first connection member; 76: second connection member; 76a: plate section; 77: third connection member; 78: fourth connection member; 78a: plate section; 79a, 79b: pin bolt; 80: base; 81a to 81e: first to fifth upper openings; 83a, 83b: first, second step sections; 84: ring-shaped passage; 85a, 85b: first, second through-holes; 86a to 86e: first to fifth sideways holes; 88a, 88b: first, second lengthwise holes; 90: valve mechanism; 91: first valve body; 92a: first cylinder section; 92b: second cylinder section; 92c: small-diameter cylinder section; 92d: bolt; 94: atmosphere connection hole; 95: second valve body; 96a: first cylinder section; 96b: second cylinder section; 96c: small-diameter cylinder section; 96d: bolt; 98: atmosphere connection hole; 100: component mounting device; 101: board; 102: base; 104: board conveyance device; 106: supporting plate; 108: conveyor belt; 110: head unit; 112: X-axis slider; 114: guide rail; 116: Y-axis slider; 118: guide rail; 120: pickup head; 134: nozzle stocker; 140: head storage area; 142: storage location; 150: reel unit; 152: feeder; 154: reel; 156: positive pressure source; 158: negative pressure source; 160: controller; 162: CPU; 164: ROM; 166: RAM; 168: HDD; 200: management computer; 220: dispensing head

## Claims

1. A board work device (100) that is configured to dispense viscous fluid onto a board (101), the board work device (100) comprising:
a dispensing head (220); provided with
a viscous fluid housing chamber (71) that is configured to house the viscous fluid;
a viscous fluid dispensing outlet (14a) connected to the viscous fluid housing chamber (71);
a valve mechanism (90) that is configured to switch to a first state in which viscous fluid at the viscous fluid dispensing outlet (14a) is pushed and dispensed via the viscous fluid housing chamber (71) and a second state in which the viscous fluid cannot be dispensed;
an operation entry section (72) that is configured to enter operations from an external section, and
a switching section (73) that is configured to switch the valve mechanism (90) based on an operation entered by an operation entry section (72); and
a head holding means (21) that is configured to hold the dispensing head (220),
wherein the head holding means (21) is configured to exchangeably hold the dispensing head (220) or a mounting head (120) that is configured to hold and releases a component, and includes an operation section (61) that is configured to operate the held mounting head (120), and
wherein the operation entry section (72) is capable of entering an operation from the operation section (61) in a state where the dispensing head (220) is held by the head holding means (21).

2. The board work device (100) according to claim 1,
wherein the operation section (61) of the head holding means (21), in a state where the head holding means (21) is holding the mounting head (120), is capable of operating an axis rotating mechanism (12, 34, 62) of the mounting head (120) that axially rotates at least one of multiple component holding tools (13) which are capable of holding and releasing a component, and, in a state where the head holding means (21) is holding the dispensing head (220), is capable of operating the operation entry section (72).

3. The board work device (100) according to claim 1 or 2,
wherein the operation entry section (72) is exposed at a connection surface with the head holding means (21) when the dispensing head (220) is held by the head holding means (21).

4. The board work device (100) according to any one of claims 1 to 3,
wherein the dispensing head (220) is provided with a first opening (81a) through which positive pressure is supplied via the head holding means (21) in a state with the dispensing head (220) being held in the head holding means (21), and a second opening (81b to 81e) through which negative pressure is supplied via the head holding means (21) in a state with the dispensing head (220) being held in the head holding means (21),
wherein the head holding means (21) is provided with a first supply outlet (32a) that is connected to the first opening (81a) and that is configured to supply positive pressure in a state with the head holding means (21) holding the dispensing head (220), and a second supply outlet (32b) that is connected to the second opening (81b to 81e) and that is configured to supply negative pressure in a state with the head holding means (21) holding the dispensing head (220), and
wherein the valve mechanism (90) is capable of switching to a first state in which the viscous fluid dispensing outlet (14a) is connected to the first opening (81a) via the viscous fluid housing chamber (71) and not connected to the second opening (81b to 81e), and a second state in which the viscous fluid dispensing outlet (14a) is connected to the second opening (81b to 81e) via the viscous fluid housing chamber (71) and not connected to the first opening (81a).

5. The board work device (100) according to any one of the claims 1 to 4,
wherein the valve mechanism (90) is capable of switching to the first state, the second state, and a third state in which the viscous fluid dispensing outlet (14a) is connected to the atmosphere via the viscous fluid housing chamber (71).

## Patentansprüche

1. Platten-Verarbeitungsvorrichtung (100), die so ausgeführt ist, dass sie viskose Flüssigkeit auf eine Platte (101) aufträgt, wobei die Platten-Verarbeitungsvorrichtung (100) umfasst:
einen Auftrage-Kopf (220), der mit
einer Kammer (71) zum Aufnehmen viskoser Flüssigkeit, die zum Aufnehmen der Viskoseflüssigkeit ausgeführt ist;
einem Auslass (14a) zum Auftragen viskoser Flüssigkeit, der mit der Kammer (71) zum Aufnehmen viskoser Flüssigkeit verbunden ist;
einem Ventil-Mechanismus (90), der so ausgeführt ist, dass er auf einen ersten Zustand, in dem viskose Flüssigkeit über die Kammer (71) zum Aufnehmen viskoser Flüssigkeit gedrückt und an dem Auslass (14a) zum Auftragen viskoser Flüssigkeit aufgetragen wird, und einen zweiten Zustand einstellt, in dem die viskose Flüssigkeit nicht abgegeben werden kann;
einen Betätigungseingabe-Teilabschnitt (72), der zum Eingeben von Betätigungen über einen externen Teilabschnitt ausgeführt ist, sowie
einen Umschalt-Teilabschnitt (73) versehen ist, der zum Umschalten des Ventilmechanismus (90) auf Basis einer über einen Betätigungseingabe-Teilabschnitt (72) eingegebenen Betätigung ausgeführt ist; und
eine Kopf-Halteeinrichtung (21), die zum Halten des Auftrage-Kopfes (220) ausgeführt ist, wobei die Kopf-Halteeinrichtung (21) so ausgeführt ist, dass sie den Auftrage-Kopf (220) oder einen Montage-Kopf (120), der zum Halten und Freigeben eines Bauteils ausgeführt ist, auswechselbar hält, und einen Betätigungs-Teilabschnitt (61) einschließt, der zum Betätigen des gehaltenen Montage-Kopfes (120) ausgeführt ist, und
mit dem Betätigungseingabe-Teilabschnitt (72) eine Betätigung über den Betätigungs-Teilabschnitt (61) in einem Zustand eingegeben werden kann, in dem der Auftrage-Kopf (220) von der Kopf-Halteeinrichtung (21) gehalten wird.

2. Platten-Verarbeitungsvorrichtung (100) nach Anspruch 1,
wobei der Betätigungs-Teilabschnitt (61) der Kopf-Halteeinrichtung (21), in einem Zustand, in dem die Kopf-Halteeinrichtung (21) den Montage-Kopf (120) hält, in der Lage ist, einen Achsen-Drehmechanismus (12, 34, 62) des Montage-Kopfes (120) zu betätigen, der wenigstens eines von mehreren Bauteil-Haltewerkzeugen (13) axial dreht, die in der Lage sind, ein Bauteil zu halten und freizugeben, und in einem Zustand, in dem die Kopf-Halteeinrichtung (21) den Auftrage-Kopf (220) hält, in der Lage ist, den Betätigungseingabe-Teilabschnitt (72) zu betätigen.

3. Platten-Verarbeitungsvorrichtung (100) nach Anspruch 1 oder 2,
wobei der Betätigungseingabe-Teilabschnitt (72) an einer Verbindungsfläche mit der Kopf-Halteeinrichtung (21) freiliegt, wenn der Auftrage-Kopf (22) von der Kopf-Halteeinrichtung (21) gehalten wird.

4. Platten-Verarbeitungsvorrichtung (100) nach einem der Ansprüche 1 bis 3,
wobei der Auftrage-Kopf (220) mit einer ersten Öffnung (81a), durch die Überdruck über die Kopf-Halteeinrichtung (21) in einem Zustand zugeführt wird, in dem der Auftrage-Kopf (220) in der Kopf-Halteeinrichtung (21) gehalten wird, sowie einer zweiten Öffnung (81b bis 81e) versehen ist, durch die Unterdruck über die Kopf-Halteeinrichtung (21) in einem Zustand zugeführt wird, in dem der Auftrage-Kopf (220) in der Kopf-Halteeinrichtung (21) gehalten wird,
wobei die Kopf-Halteeinrichtung (21) mit einem ersten Zufuhr-Auslass (32a), der mit der ersten Öffnung (81a) verbunden ist und der so ausgeführt ist, dass er Überdruck in einem Zustand zuführt, in dem die Kopf-Halteeinrichtung (21) den Auftrage-Kopf (220) hält, sowie einem zweiten Zufuhr-Auslass (32b) versehen ist, der mit der zweiten Öffnung (81b bis 81e) verbunden ist und der so ausgeführt ist, dass er Unterdruck in einem Zustand zuführt, in dem die Kopf-Halteeinrichtung (21) den Auftrage-Kopf (220) hält, und
der Ventil-Mechanismus (90) in der Lage ist, auf einen ersten Zustand, in dem der Auslass (14a) zum Auftragen viskoser Flüssigkeit über die Kammer (71) zum Aufnehmen viskoser Flüssigkeit mit der ersten Öffnung (81a) verbunden ist und nicht mit der zweiten Öffnung (81b bis 81e) verbunden ist, und einen zweiten Zustand einzustellen, in dem der Auslass (14a) zum Auftragen viskoser Flüssigkeit über die Kammer (71) zum Aufnehmen viskoser Flüssigkeit mit der zweiten Öffnung (81b bis 81e) verbunden ist und nicht mit der ersten Öffnung (81a) verbunden ist.

5. Platten-Verarbeitungsvorrichtung (100) nach einem der Ansprüche 1 bis 4,
wobei der Ventil-Mechanismus (90) in der Lage ist, auf den ersten Zustand, den zweiten Zustand und einen dritten Zustand einzustellen, in dem der Auslass (14a) zum Auftragen viskoser Flüssigkeit über die Kammer (71) zum Aufnehmen viskoser Flüssigkeit mit der Atmosphäre verbunden ist.

## Revendications

1. Dispositif de travail sur carte (100) configuré pour distribuer un fluide visqueux sur une carte (101), le dispositif de travail sur carte (100) comprenant :
une tête de distribution (220) ; pourvue
d'une chambre de réception de fluide visqueux (71) qui est configurée pour contenir le fluide visqueux ;
d'une sortie de distribution de fluide visqueux (14a) connectée à la chambre de réception de fluide visqueux (71) ;
d'un mécanisme de vanne (90) qui est configuré pour commuter entre un premier état dans lequel du fluide visqueux provenant de la sortie de distribution de fluide visqueux (14a) est poussé et distribué via la chambre de réception de fluide visqueux (71) et un deuxième état dans lequel le fluide visqueux ne peut pas être distribué ;
d'une section d'entrée d'opérations (72) qui est configurée pour entrer des opérations provenant d'une section externe, et
d'une section de commutation (73) qui est configurée pour commuter le mécanisme de vanne (90) sur base d'une opération entrée par une section d'entrée d'opérations (72) ; et
un moyen de maintien de tête (21) qui est configuré pour maintenir la tête de distribution (220),
dans lequel le moyen de maintien de tête (21) est configuré pour maintenir de manière échangeable la tête de distribution (220) ou une tête de montage (120) qui est configurée pour maintenir et libérer un composant, et qui comprend une section d'opération (61) qui est configurée pour effectuer une opération avec la tête de montage maintenue (120), et
dans lequel la section d'entrée d'opérations (72) est capable d'entrer une opération provenant de la section d'opération (61) dans un état où la tête de distribution (220) est maintenue par le moyen de maintien de tête (21).

2. Dispositif de travail sur carte (100) selon la revendication 1,
dans lequel la section d'opération (61) du moyen de maintien de tête (21), dans un état où le moyen de maintien de tête (21) maintient la tête de montage (120), est capable d'effectuer une opération avec un mécanisme de rotation axiale (12, 34, 62) de la tête de montage (120) pour faire tourner axialement au moins un outil parmi de multiples outils de maintien de composants (13) qui sont capables de maintenir et de libérer un composant, et, dans un état où le moyen de maintien de tête (21) maintient la tête de distribution (220), est capable d'effectuer une opération avec la section d'entrée d'opérations (72).

3. Dispositif de travail sur carte (100) selon la revendication 1 ou 2,
dans lequel la section d'entrée d'opérations (72) est exposée à une surface de connexion avec le moyen de maintien de tête (21) quand la tête de distribution (220) est maintenue par le moyen de maintien de tête (21).

4. Dispositif de travail sur carte (100) selon l'une quelconque des revendications 1 à 3,
dans lequel la tête de distribution (220) est pourvue d'une première ouverture (81a) à travers laquelle une pression positive est appliquée via le moyen de maintien de tête (21) dans un état avec la tête de distribution (220) maintenue dans le moyen de maintien de tête (21), et une deuxième ouverture (81b à 81e) à travers laquelle une pression négative est appliquée via le moyen de maintien de tête (21) dans un état où la tête de distribution (220) est maintenue dans le moyen de maintien de tête (21),
dans lequel le moyen de maintien de tête (21) est pourvu d'une première sortie d'alimentation (32a) qui est connectée à la première ouverture (81a) et qui est configurée pour appliquer une pression positive dans un état où le moyen de maintien de tête (21) maintient la tête de distribution (220), et une deuxième sortie d'alimentation (32b) qui est connectée à la deuxième ouverture (81b à 81e) et qui est configurée pour appliquer une pression négative dans un état où le moyen de maintien de tête (21) maintient la tête de distribution (220), et
dans lequel le mécanisme de vanne (90) est capable de commuter dans un premier état où la sortie de distribution de fluide visqueux (14a) est connectée à la première ouverture (81a) via la chambre de réception de fluide visqueux (71) et n'est pas connectée à la deuxième ouverture (81b à 81e), et dans un deuxième état où la sortie de distribution de fluide visqueux (14a) est connectée à la deuxième ouverture (81b à 81e) via la chambre de réception de fluide visqueux (71) et n'est pas connectée à la première ouverture (81a).

5. Dispositif de travail sur carte (100) selon l'une quelconque des revendications 1 à 4,
dans lequel le mécanisme de vanne (90) est capable de commuter dans le premier état, le deuxième état, et un troisième état dans lequel la sortie de distribution de fluide visqueux (14a) est connectée à l'atmosphère via la chambre de réception de fluide visqueux (71).
